# EUROPÄISCHE PATENTSCHRIFT

(11) **EP 0 834 753 B1**
(45) Veröffentlichungstag und Bekanntmachung des Hinweises auf die Patenterteilung: **13.10.2004**
(21) Anmeldenummer: 97114837.4
(22) Anmeldetag: 27.08.1997
(51) Int. Cl.: G02B 5/30

(54) **Doppelbrechende Planplattenanordnung und DUV-Viertelwellenplatte**
Device comprising a birefringent planar plate and DUV-quarter-wave plate
Dispositif à lame biréfringente plane et lame quart d'onde dans l'UV lointain

(30) Priorität: 14.09.1996 DE 19637563
(43) Veröffentlichungstag der Anmeldung: 08.04.1998
(73) Patentinhaber: Carl Zeiss SMT AG, 73447 Oberkochen (DE)
(72) Erfinder: Schuster, Karl Heinz, 89551 Königsbronn (DE)
(74) Vertreter: Müller-Rissmann, Werner Albrecht, Dr.

(56) Entgegenhaltungen:
- FR-A- 2 211 667
- GB-A- 1 098 897
- DELPLANCKE F ET AL: "SIMPLE PROCESS FOR BUILDING LARGE HOMOGENEOUS ADAPTABLE RETARDERS MADE FROM POLYMERIC MATERIALS" APPLIED OPTICS, Bd. 34, Nr. 16, 1.Juni 1995, Seiten 2921-2926, XP000506373

## Beschreibung

Die Erfindung betrifft eine doppelbrechende Planplattenanordnung mit Spannungsdoppelbrechung nach dem Oberbegriff des Anspruchs 1 und eine dementsprechende DUV-taugliche Viertelwellenlängenplatte nach Anspruch 16.

Phasenverzögerungsplatten können heute für den sichtbaren Spektralbereich etwa bis zu einem Durchmesser von 300 mm, in ausgezeichneter Verzögerungstoleranz ± 5 % für Lambda/4 und mit sehr gutem optischem Durchgang hergestellt werden. Dazu wird gereckte Polyvinylalkohol-Folie zwischen optischen Scheiben verkittet. Leider sind diese Folien bei der Projektions-Mikrolithographie mit DUV-Licht, zum Beispiel der Wellenlänge 193 nm, nicht anwendbar, da weder Kitt noch Folie der Strahlungsbelastung gewachsen sind.

Die in Frage kommenden doppelbrechenden kristallinen Materialien sind SiO₂ und MgF₂. Benötigt man Lambdaviertel-Platten mit einem Durchmesser von etwa 200 mm, so wird es für SiO₂ sehr unwahrscheinlich, geeignetes Material zu bekommen. Ideal ist eine Verzögerungsplatte einfacher Dicke. Dabei errechnet sich die Dicke nach der Formel:
d = (k · Lambda) : Δn . Die resultierenden Plattendicken sind für SiO₂ und MgF₂ fast gleich. Für Quarzkristall ist bei 193 nm die Differenz der Brechzahlen Δn = 0,0135, damit resultiert eine Plattendicke d = 3,57 µm. Dies ist schon sehr wenig. Obwohl Quarz sehr gut ansprengbar ist, sollte wenigstens eine dreifache Dicke angestrebt werden, um mit 10 µm eine gewisse mechanische Stabilität zu erreichen. Diese Dicke ist aber wegen der optischen Störung des Objektivs nicht akzeptabel.

Eine Viertelwellenplatte für 633 nm Wellenlänge aus Quarz mit dem Durchmesser 150 mm und ca. 16 µm Dicke hat Carl Zeiss Oberkochen schon hergestellt.

Das eigentliche Problem besteht in der Verfügbarkeit des SiO₂ in der benötigten Größe. Synthetischer Kristall erreicht zwar als Platte die Größe, jedoch liegt die Kristallachse senkrecht zur Plattenebene und nicht wie gefordert in Plattenebene. Die Wachstumsgeschwindigkeiten bei der Kristallzüchtung sind deutlich unterschiedlich, insbesondere in Richtung der Kristallachse am langsamsten. Synthetische Stücke mit einer Abmessung in Richtung der Kristallachse größer als 100 mm sind aus damit zusammenhängenden Gründen nicht bekannt.

Natürliche Quarzkristalle können in Einzelfällen die geforderte Größe erreichen. Damit läßt sich aber keine gesicherte Produktion erreichen, da alle bekannten natürlichen Lagerstätten ausgeräumt sind.

Die Alternative zum Quarz ist synthetisch hergestelltes MgF₂. Allerdings gibt es auch hier Probleme bei der Züchtung von derart großen Stücken, da MgF₂ unterschiedliche thermische Ausdehnungskoeffizienten für die unterschiedlichen Richtungen im Kristall besitzt. Große Kristalle müssen thermisch sehr behutsam gefahren werden, damit sie nicht platzen. Erschwerend kommt hinzu, daß MgF₂ nicht ansprengbar ist. Bei der Bearbeitung müßte also über Kitten gearbeitet werden. Später müßte eine wenige Mikrometer dicke Platte zwischen zwei Quarzglasplatten mit Immersion im optischen Kontakt gehalten werden.

Bei Δn von MgF₂ bei 193 nmm gleich 0,0136 beträgt die einfache Plattendicke für MgF₂ 3,54 µm.

Die optische Phasenverzögerung kann auch durch Drücken oder Dehnen eines zunächst isotropen Materials erreicht werden, dadurch wird Spannungsdoppelbrechung erzeugt. Es kommen nur für DUV, insbesondere für 193 nm, durchlässige und für den geforderten Durchmesser verfügbare Materialien in Betracht. Da die Strahlungsbelastung aufgrund des großen Durchmessers reduziert ist, kann auch Quarzglas eingesetzt werden.

Die Frage, ob Druck oder Zug, ist zugunsten von Zug zu beantworten: Bei Druck könnte sich die Platte verbiegen, was in einem Projektionsobjektiv völlig unbrauchbar ist. Bei Zug wird die Ebenheit und damit der optische Durchgang verbessert.

Der Artikel von Delplancke et al : " simple pocess for building large homogeneous adaptable retarders made from polymeric materials", Applied Optics, Vol. 34, N. 16, June 1995, offenbart ein Verfahren zur Herstellung einer Verzögerungsplatte, bei dem die Platte einer Zugspannung ausgesetzt wird. Es wird eine Verzögerungsplatte mit verhältnismässig kleiner optisch nutzbarer Fläche erzeugt, während im übrigen Bereich der Platte erhebliche Spannungsinhomogenitäten auftreten.

Aufgabe der Erfindung ist die Bereitstellung einer Anordnung, mit der eine Spannungsdoppelbrechung aufweisende dünne Planplatte beträchtlicher Ausmaße bereitgestellt wird, die als DUV-Viertelwellenplatte für Mikrolithographie-Projektionsbelichtungsanlagen Verwendung finden kann. Dazu ist eine großflächig homogene Zugspannung in der Planplatte zu erreichen.

Die Lösung dieser Aufgabe gelingt durch eine doppelbrechende Planplattenanordnung nach Anspruch 1 bzw. durch die Viertelwellenplatte nach Anspruch 16.

Vorteilhafte Ausführungsformen sind Gegenstand der Unteransprüche 2-15.

Durch diese Fassungstechnik gelingt es erstmals, eine großflächige DUV-taugliche Lambdaviertelplatte mit Spannungsdoppelbrechung zu realisieren.

Näher erläutert wird die Erfindung anhand der Zeichnungen. Es zeigen:
- Figur 1: die schematische Gesamtansicht einer erfindungsgemäßen Planplattenanordnung;
- Figur 2: einen Ausschnitt mit einer formschlüssigen Krafteinleitung in die Planplatte.

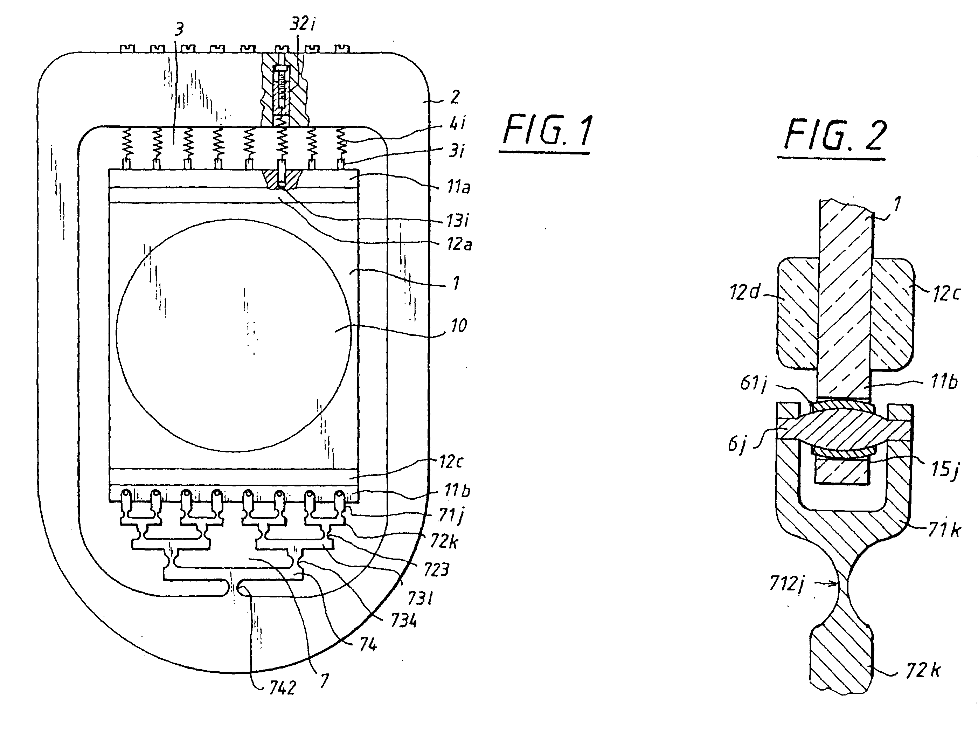

Die Anordnung der Fig. 1 zeigt zunächst als Hauptbestandteil eine Planplatte 1 aus Quarzglas hoher Güte und UV-Beständigkeit mit den Abmessungen von typisch 220 x 280 x 10 mm³ (Breite x Höhe x Dicke). In dem kreisförmigen Querschnitt 10 von ca 200 bis 210 mm Durchmesser wird sie von UV-Licht,

insbesondere eines Excimer-Lasers mit unter 250nm Wellenlänge, z.B. eines ArF-Lasers mit 193 nm, durchstrahlt. Die Anwendung erfolgt zum Beispiel im Projektionsobjektiv einer Mikrolithographie-Projektionsbelichtungsanlage. Bedarf besteht besonders bei katadioptrischen Systemen mit Strahlteilerwürfel, wie z.B. in DE 196 16 922.4 und den dort zitierten Schriften beschrieben.

Die Planplatte 1 ist feinoptisch planpoliert und mit Entspiegelungsschichten vergütet. Diese Planplatte 1 bildet aufgrund der Spannungsdoppelbrechung eine Viertelwellenplatte (Lambda-Viertel-Platte) bei einer Zugspannung von 1,36 N/mm. (Bei 5 mm Plattendicke 2,72 N/mm). Diese Zugspannung muß von den Zugvorrichtungen 3, 7 mit hoher Gleichmäßigkeit und ohne Biegemomente in die Planplatte 1 eingebracht werden, damit die benötigte Wirkung im ganzen Querschnitt 10 gleichmäßig und ungestört realisiert wird.

Die Zugvorrichtung 3 im oberen und die Zugvorrichtung 7 im unteren Teil der Figur 1 zeigen Beispiele, wie diese gleichmäßige Zugspannung von dem steifen Spannrahmen 2 in die Planplatte 1 eingebracht werden kann.

Zwischen dem nutzbaren Querschnitt 10 und den Ansatzbereichen 11a und 11b oben und unten sind jeweils Querbalken 12a bis 12d aus dem gleichen Quarzglas mit einem Format von zum Beispiel 220 x 30 x 15 mm³ (Breite x Höhe x Dicke) beidseitig angesprengt oder angekittet. Diese Versteifungen bewirken eine Gleichverteilung der Zugspannung von den zahlreichen, doch aber diskreten Ansatzpunkten der Zugvorrichtungen 3, 7 auf die Planplatte 1 im Bereich zwischen den Querbalken 12a bis 12d (Vermeidung des "Vorhang"-Effekts).

Die obere Zugvorrichtung 3 hat stirnseitige Bohrungen 12i in der Planplatte 1 (z.B 5 mm Durchmesser, 10 mm Tiefe, 10 mm Abstand). Darin sind Stifte 13i aus Invar - das Material verträgt sich hinsichtlich der Wärmeausdehnung besonders gut mit Quarzglas - mit UV-beständigem Kitt eingeklebt. Alternativ ist auch eine Lötung, z.B. mit vorangehender Metallisierung des Quarzglases durch Vakuumbeschichten oder Elektrolyse, möglich. Zum Schutz einer Klebung gegen das aggressive UV-Licht, das durch Streuung auch unvermeidlich in kleinen Bruchteilen die Verankerungen 12i, 13i erreicht, kann z.B. Ruß als Absorber dem Kitt untergemischt sein.

Die freien Enden der Stifte 13i tragen Ösen, in die Schrauben-Zugfedern 3i eingehängt sind. Mit dem zweiten Ende sind diese Federn 3i in längsverstellbare Lagerböcke 32i eingehängt, die im Spannrahmen 2 fest gelagert sind. Durch Justage der längsverstellbaren Lagerböcke 32i wird die gleichmäßige Spannung in der Planplatte 1 eingestellt. Dazu werden die Spannungen im Quarzglas interferometrisch ausgewertet.

Natürlich kann diese Zugvorrichtung 3 beidseitig zwischen Planplatte 1 und Spannrahmen 2 angeordnet werden.

Im Beispiel wird an der Unterseite jedoch eine andere Variante einer Zugvorrichtung 7 gezeigt. Der Ausschnitt der Figur 2 verdeutlicht dazu in Querschnittsdarstellung die formschlüssige torsionsfreie Krafteinleitung in die Planplatte 1. Hierzu trägt die Planplatte eine Vielzahl von Querbohrungen 15j in gleichmäßigem Abstand (z.B. Durchmesser 10 mm, Abstand 10 mm).

Beim Herstellen der Bohrungen 15j ist darauf zu achten, daß diese nicht ausfransen. Deshalb werden beim Bohren oberhalb und unterhalb der Bohrstelle, bzw. auf beiden Seiten der Platte 1, verlorene Hilfsstücke aufgekittet. So werden unnötige Risse und Ausmuschelungen, die die Sicherheit des Bauteils herabsetzen, vermieden. Danach erfolgt erst die feinoptische Bearbeitung der Planflächen. Weiterhin ist es vorteilhaft, die Teile in Flußsäure zu ätzen, um Risse auszuätzen. Auch Tempern verbessert die Rißempfindlichkeit.

In die Bohrungen 15j sind ballig geformte Bolzen 6j, z.B. aus gehärtetem Stahl oder aus Invar, gesteckt. Vorzugsweise ist eine dünne Hülse 61j aus weichem duktilem Material, z.B. Kupfer oder Zinn, zwischengelegt. So ist eine formschlüssige, torsionsfreie Verbindung der Planplatte 1 mit den Bolzen 6j erzielt, bei der überhöhte lokale Belastungen durch die Hülse 61j vermieden werden.

An diese Bolzen 6j greift die Zugvorrichtung 7 an. Zunächst sind die Bolzen 6j beidseitig in einem Joch 71j aufgenommen. Das Joch 71j ist über ein Federgelenk 712j mit einem Ausgleichsbalken 72k verbunden. Mit mehreren parallel und in Serie geschalteten Ausgleichsbalken 72k, 73l, 74 mit Federgelenken 723, 734, 742 ist ein Ausgleichshebelgetriebe gebildet, welches für gleichmäßige Zugbelastung aller Bolzen 6j sorgt. Die Federgelenke 712j, 723, 734, 742 sind weich gegen Torsion und Biegung in der Zeichenebene von Figur 1 und senkrecht dazu ausgebildet, so daß keine Biegemomente auf die Planplatte 1 übertragen werden. Über das Federgelenk 742 ist die Zugvorrichtung 7 mit dem Spannrahmen 2 verbunden. Die Herstellung des Ausgleichshebelgetriebes in der dargestellten Form gelingt z.B. mit Funkenerosion, Wasserstrahlschneiden oder Laserbearbeitung. Natürlich ist die Anzahl der Bohrungen 15j und damit der Hebel und Gelenke in der Praxis größer (10¹ bis 10² Stück) als in der schematischen Zeichnung Figur 1 und 2.

Statt der dargestellten Federgelenke kommen auch Kugelgelenke in Frage oder mehrteilige Federgelenkkonstruktionen. Zur Justage kann die Steifigkeit der Ausgleichsbalken 72k, 73l, 74 und Federgelenke 723, 734, 742 durch Materialabtrag z.B. mit Laser gezielt verändert werden.

Auch diese Zugvorrichtung kann beidseitig vorgesehen werden, sie kann aber auch z.B. mit den Zugfedern oder den eingeklebten Stiften der Zugvorrichtung 3 kombiniert werden. Genauso können die Federn der Zugvorrichtung 3 über Joche und Bolzen an Querbohrungen der Planplatte 1 angreifen.

Alternative Verbindungen der Quarzplatte zu Metallteilen der Zugvorrichtung können in Klebetechnik auch eine Verzinkung, speziell eine Keilverzinkung, vorsehen, wobei das Metallteil dann in eine Vielzahl gegeneinander beweglicher Glieder, vorzugsweise mit Federgelenken, aufgelöst ist. Die Form des Quarzglasteils berücksichtigt dabei stets genügend ausgebildete Rundungen, um Kerbwirkungen in dem spröden Material zu vermeiden.

Formschlüssige Verbindungen können dabei auch als Schwalbenschwanzverzinkungen ausgebildet sein, mit in Dickenrichtung angeordneten Stegen oder einem in Breitenrichtung verlaufenden Steg. Auch Verkeilungen sind möglich.

Die metallischen Teile sind ebenfalls vielteilig ausgeführt, um eine gute Passung und gleichmäßige torsionsfreie Zugbelastung zu sichern.

Alle Grenzflächen zwischen Quarzglas und Metall wie auch zwischen relativ beweglichen Metallteilen können mit Schichten oder Einlagen aus weichem Metall oder PTFE zur Lastverteilung und Reibungsminderung optimiert werden.

Gezielt kann die Spannungsverteilung in der Planplatte auch gering von der Homogenität abweichen und insbesondere ein Querprofil aufweisen, wenn die lokale Zugspannung entsprechend einreguliert wird. Damit können z.B. Inhomogenitäten der Polarisation des durchtretenden Lichtbündels, verursacht z.B. durch Restfehler des Polteilerwürfels bei einem katadioptrischen Objektiv, ausgeglichen werden.

Zusätzlich zur Zugspannung eingebrachte Druckkräfte quer dazu können die Spannungsdoppelbrechung erhöhen, ohne daß die Belastungsgrenze des Quarzglases überschritten wird. Durch die dominierende Zugspannung ist dann das Durchbiegen unter Druck vermieden.

Abweichungen der Planplatte von der Idealform - hierzu gehört die Querkontraktion unter Zug, die eine Zylinderlinsenwirkung verursacht, und die meniskenartige Durchbiegung unter der Schwerkraft bei horizontaler Einbaulage - können durch Vorhalt in der Fertigung mit geeignet gebogenen Flächen kompensiert werden. Die Durchbiegung unter Schwerkraft kann auch durch geeignete Auflager außerhalb des optisch genutzten Querschnitts 10 gemindert werden.

## Patentansprüche

1. Doppelbrechende Planplattenanordnung mit Spannungsdoppelbrechung, mit einem optisch nutzbaren Mittelbereich (10) und zwei Kuppelbereichen (11a, 11b) an zwei gegenüberliegenden Seiten einer Planplatte (1), an denen jeweils eine Zugvorrichtung (3, 7) über eine Vielzahl von Ansatzpunkten angreift, **dadurch gekennzeichnet, daß** zwischen optisch nutzbarem Mittelbereich (10) und den zwei Kuppelbereichen (11a, 11b) jeweils ein Querbalken (12a-d) kraftschlüssig mit der Planplatte (1) verbunden ist.

2. Doppelbrechende Planplattenanordnung nach Anspruch 1, **dadurch gekennzeichnet, daß** zumindest eine Zugvorrichtung (3) Zugfedern (3i) enthält.

3. Doppelbrechende Planplattenanordnung nach Anspruch 1 oder 2, **dadurch gekennzeichnet, daß** zumindest eine Zugvorrichtung (7) ein Ausgleichshebelgetriebe (71, 73, 74) aufweist.

4. Doppelbrechende Planplattenanordnung nach mindestens einem der Ansprüche 1-3, **dadurch gekennzeichnet, daß** die Zugvorrichtungen (7) kittfrei mit der Planplatte (1) verbunden sind.

5. Doppelbrechende Planplattenanordnung nach Anspruch 1, welche an den gegenüberliegenden Seiten eine Mehrzahl paralleler Querbohrungen (15j) aufweist, in die ballig geformte Bolzen (6j) der Zugvorrichtung (7) eingreifen, welche in Jochen (71j) der Zugvorrichtung (7) gelagert sind, die wiederum torsionsfrei in der Ebene der Planplatte (1) auf Zug beansprucht gelagert sind.

6. Doppelbrechende Planplattenanordnung nach Anspruch 5, **dadurch gekennzeichnet, daß** die Bolzen (6j) einen harten Kern und eine plastisch verformbare Hülse (61j) aufweisen.

7. Doppelbrechende Planplattenanordnung nach Anspruch 1, **dadurch gekennzeichnet, daß** die Querbalken (12a-d) angesprengt sind.

8. Doppelbrechende Planplattenanordnung nach mindestens einem der Ansprüche 1-7, **dadurch gekennzeichnet, daß** der Durchmesser des optisch nutzbaren Mittelbereichs (10) größer als 180 mm ist.

9. Doppelbrechende Planplattenanordnung nach mindestens einem der Ansprüche 1-8, **dadurch gekennzeichnet, daß** die Dicke der Planplatte etwa 5-15 mm beträgt.

10. Doppelbrechende Planplattenanordnung nach Anspruch 3, **dadurch gekennzeichnet, daß** das Ausgleichshebelgetriebe (72, 73, 74) mit Federgelenken (723, 734, 742) aufgebaut ist.

11. Doppelbrechende Planplattenanordnung nach Anspruch 10, **dadurch gekennzeichnet, daß** das Ausgleichshebelgetriebe (72, 73, 74) für eine Seite einstückig ausgebildet ist.

12. Doppelbrechende Planplattenanordnung nach mindestens einem der Ansprüche 1-11, **dadurch gekennzeichnet, daß** die Planplatte (1) unter der angelegten Zugspannung eine Viertelwellenlängenplatte für die Betriebswellenlänge im Ultravioletten ist.

13. Doppelbrechende Planplattenanordnung nach mindestens einem der Ansprüche 1-12, **dadurch gekennzeichnet, daß** die Planplatte (1) aus Glas, insbesondere aus Quarzglas, besteht.

14. Doppelbrechende Planplattenanordnung nach mindestens einem der Ansprüche 1-13, **dadurch gekennzeichnet, daß** die Planplatte (1) und die Querbalken (12a-d) aus demselben Material, insbesondere aus Quarzglas bestehen.

15. Doppelbrechende Planplattenanordnung nach mindestens einem der Ansprüche 1-14, **dadurch gekennzeichnet, daß** die Planplatte (1) im tiefen Ultraviolett unterhalb 250 nm, besonders auch im Bereich 200 nm bis 150 nm transparent und strahlungsstabil ist.

16. Doppelbrechende Planplattenanordnung nach Anspruch 15, **dadurch gekennzeichnet, daß** die Planplatte aus Glas ist und derart unter einer gleichmäßigen Zugspannung steht, dass sie eine im tiefen Ultraviolett unterhalb 250mm transparente Viertelwellenlängenplatte ist.

17. Doppelbrechende Planplattenanordnung nach mindestens einem der Ansprüche 1-13, **dadurch gekennzeichnet, daß** UV-Licht, insbesondere eines Excimer-Lasers mit unter 250 nm Wellenlänge, den optischen nutzbaren Mittelbereich (10) durchstrahlt.

## Claims

1. Bifringent planar plate arrangement with stress-induced bifringence, having an optically useful middle region (10) and two coupling regions (11a, 11b) which are on two opposite sides of a planar plate (1) and on which a tensioning device (3, 7) respectively acts via a multiplicity of attachment points, **characterized in that** in each case a transverse beam (12a-d) is connected to the planar plate (1) in a force-closed fashion between the optically useful middle region (10) and two coupling regions (11a, 11b).

2. Bifringent planar plate arrangement according to Claim 1, **characterized in that** at least one tensioning device (3) includes tension springs (3i).

3. Bifringent planar plate arrangement according to Claim 1 or 2, **characterized in that** at least one tensioning device (7) has a compensating lever mechanism (72, 73, 74).

4. Bifringent planar plate arrangement according to at least one of Claims 1-3, **characterized in that** the tensioning devices (7) are connected to a planar plate (1) without cement.

5. Bifringent planar plate arrangement according to Claim 1, which has on the opposite sides a plurality of parallel transverse bores (15j) into which there engage spherically shaped bolts (6j) of the tensioning device (7) which are mounted in yokes (71j) of the tensioning device (7) which are mounted, in turn, under tension without torsion in the plane of the planar plate (1).

6. Bifringent planar plate arrangement according to Claim 5, **characterized in that** the bolts (6j) have a hard core and a plastically deformable sleeve (61j).

7. Bifringent planar plate arrangement according to Claim 1, **characterized in that** the transverse beams (12a-d) are wrung.

8. Bifringent planar plate arrangement according to at least one of Claims 1-7, **characterized in that** the diameter of the optically useful middle region (10) is greater than 180 mm.

9. Bifringent planar plate arrangement according to at least one of Claims 1-8, **characterized in that** the thickness of the planar plate is approximately 5-15 mm.

10. Bifringent planar plate arrangement according to Claim 3, **characterized in that** the compensating lever mechanism (72, 73, 74) is constructed with spring joints (723, 734, 742).

11. Bifringent planar plate arrangement according to Claim 10, **characterized in that** the compensating lever mechanism (72, 73, 74) for one side is designed in one piece.

12. Bifringent planar plate arrangement according to at least one of Claims 1-11, **characterized in that** the planar plate (1) under the applied tensile stress is a λ/4 plate for an operating wavelength in the ultraviolet.

13. Bifringent planar plate arrangement according to at least one of Claims 1-12, **characterized in that** the planar plate (1) consists of glass, in particular of fused silica.

14. Bifringent planar plate arrangement according to at least one of Claims 1-13, **characterized in that** the planar plate (1) and the transverse beams (12a-d) consists of the same material, in particular of fused silica.

15. Bifringent planar plate arrangement according to at least one of Claims 1-14, **characterized in that** the planar plate (1) is transparent and radiation-stable in the deep ultraviolet below 250 nm, particularly also in the range of 200 nm to 150 nm.

16. Bifringent planar plate arrangement according to Claim 15, **characterized in that** the planar plate is made from glass and is subjected to a uniform tensile stress in such a way that it is a λ/4 plate which is transparent in the deep ultraviolet below 250 nm.

17. Bifringent planar plate arrangement according to at least one of Claims 1-13, **characterized in that** UV light, in particular of an Excimer laser with a wavelength below 250 nm, transirradiates the optically useful middle region (10).

## Revendications

1. Dispositif à lame biréfringente plane avec biréfringence par compression, comprenant une zone centrale (10) utilisable de manière optique et deux zones de couplage (11a, 11b) sur deux côtés opposés d'une lame plane (1), sur lesquelles intervient à chaque fois un dispositif de traction (3, 7) par le biais d'une pluralité de points d'appui, **caractérisé en ce qu'**une traverse (12a-d) est à chaque fois reliée par engagement de force avec la lame plane (1) entre la zone centrale (10) utilisable de manière optique et les deux zones de couplage (11a, 11b).

2. Dispositif à lame biréfringente plane selon la revendication 1, **caractérisé en ce qu'**au moins un dispositif de traction (3) contient des ressorts de traction (3i).

3. Dispositif à lame biréfringente plane selon la revendication 1 ou 2, **caractérisé en ce qu'**au moins un dispositif de traction (7) présente un engrenage à levier de compensation (72, 73, 74).

4. Dispositif à lame biréfringente plane selon au moins l'une des revendications 1 à 3, **caractérisé en ce que** les dispositifs de traction (7) sont reliés sans mastic à la lame plane (1).

5. Dispositif à lame biréfringente plane selon la revendication 1, lequel présente sur les côtés opposés une pluralité de trous transversaux parallèles (15j) dans lesquels pénètrent les goujons (6j) de forme bombée du dispositif de traction (7), lesquels sont logés dans les entretoises (71j) du dispositif de traction (7), lesquelles sont à leur tour logées sans torsion avec contrainte de traction dans le plan de la lame plane (1).

6. Dispositif à lame biréfringente plane selon la revendication 5, **caractérisé en ce que** les goujons (6j) présentent un noyau dur et une douille (61j) pouvant subir une déformation plastique.

7. Dispositif à lame biréfringente plane selon la revendication 1, **caractérisé en ce que** les traverses (12a-d) sont accolées.

8. Dispositif à lame biréfringente plane selon au moins l'une des revendications 1 à 7, **caractérisé en ce que** le diamètre de la zone centrale (10) utilisable de manière optique est supérieur à 180 mm.

9. Dispositif à lame biréfringente plane selon au moins l'une des revendications 1 à 8, **caractérisé en ce que** l'épaisseur de la lame plane est comprise entre environ 5 à 15 mm.

10. Dispositif à lame biréfringente plane selon la revendication 3, **caractérisé en ce que** l'engrenage à levier de compensation (72, 73, 74) est constitué d'articulations à ressort (723, 734, 742).

11. Dispositif à lame biréfringente plane selon la revendication 10, **caractérisé en ce que** l'engrenage à levier de compensation (72, 73, 74) est configuré d'une seule pièce pour un côté.

12. Dispositif à lame biréfringente plane selon au moins l'une des revendications 1 à 11, **caractérisé en ce que** la lame plane (1) sous la contrainte de traction appliquée est une lame quart d'onde pour la longueur d'onde de service dans l'ultraviolet.

13. Dispositif à lame biréfringente plane selon au moins l'une des revendications 1 à 12, **caractérisé en ce que** la lame plane (1) est en verre, notamment en verre de quartz.

14. Dispositif à lame biréfringente plane selon au moins l'une des revendications 1 à 13, **caractérisé en ce que** la lame plane (1) et les traverses (12ad) se composent du même matériau, notamment du verre de quartz.

15. Dispositif à lame biréfringente plane selon au moins l'une des revendications 1 à 14, **caractérisé en ce que** la lame plane (1) est transparente et stable au rayonnement dans l'ultraviolet profond à moins de 250 nm, plus particulièrement aussi dans la plage comprise entre 200 nm et 150 nm.

16. Dispositif à lame biréfringente plane selon la revendication 15, **caractérisé en ce que** la lame plane est en verre et elle se trouve sous une contrainte de traction régulière de telle manière à être une lame quart d'onde transparente dans l'ultraviolet profond à moins de 250 nm.

17. Dispositif à lame biréfringente plane selon au moins l'une des revendications 1 à 13, **caractérisé en ce que** la lumière UV, notamment d'un laser Excimer ayant une longueur d'onde inférieure à 250 nm traverse la zone centrale (10) utilisable de manière optique.
